Europäisches Patentamt

European Patent Office

Office européen des brevets

(11) Veröffentlichungsnummer: **0 069 823**
**B1**

(12) **EUROPÄISCHE PATENTSCHRIFT**

(45) Veröffentlichungstag der Patentschrift:
10.07.85

(21) Anmeldenummer: 82102220.9

(22) Anmeldetag: 18.03.82

(51) Int. Cl.⁴: **G 03 F 9/00**, G 03 F 7/20,
H 01 J 37/20, H 01 J 37/304,
H 01 L 21/68, H 01 L 21/26,
H 01 L 21/42, G 02 B 27/00,
H 05 K 3/10

(54) Verfahren und Einrichtung zur gegenseitigen Ausrichtung von Objekten bei Röntgenstrahl- und Ionenstrahl-Lithographie.

(30) Priorität: 30.05.81 DE 3121666

(43) Veröffentlichungstag der Anmeldung:
19.01.83 Patentblatt 83/3

(45) Bekanntmachung des Hinweises auf die Patenterteilung:
10.07.85 Patentblatt 85/28

(84) Benannte Vertragsstaaten:
DE FR GB IT

(56) Entgegenhaltungen:
EP - A - 0 009 562
EP - A - 0 027 497
EP - A - 0 043 863
DE - A - 2 702 444
DE - A - 2 722 958
DE - A - 2 739 502
US - A - 3 326 170

SOLID STATE TECHNOLOGY, Band 15, No. 7, Juli 1972,
Port Washington (US) D.L. SPEARS, H.I. SMITH "X-Ray
Lithography - A New High Resolution Replication
Process" Seiten 21-26
SOLID STATE TECHNOLOGY, Band 17, No. 7, Juli 1974,
Port Washington (US) W.R. LIVESAY "Computer
Controlled Electron - Beam Projection Mask Aligner"
Seiten 21-26

(73) Patentinhaber: **IBM DEUTSCHLAND GMBH,
Pascalstrasse 100, D-7000 Stuttgart 80 (DE)**
(84) Benannte Vertragsstaaten: **DE**

(73) Patentinhaber: **International Business Machines
Corporation, Old Orchard Road, Armonk, N.Y. 10504 (US)**
(84) Benannte Vertragsstaaten: **FR GB IT**

(72) Erfinder: **Bohlen, Harald, Dipl.-Phys., Geleener
Strasse 26, D-7030 Böblingen (DE)**
Erfinder: **Engelke, Helmut, Dr. Dipl.-Phys., Ahornweg 33,
D-7031 Altdorf (DE)**
Erfinder: **Greschner, Johann, Dr. Dipl.-Phys.,
Zollernstrasse 14, D-7401 Pliezhausen (4) (DE)**
Erfinder: **Mühl, Reinhold, Würmstrasse 43,
D-7031 Altdorf (DE)**
Erfinder: **Nehmiz, Peter, Dr. Dipl.-Phys.,
Karl-Weller-Strasse 2, D-7000 Stuttgart 80 (DE)**
Erfinder: **Trumpp, Hans-Joachim, Dr. Dipl.-Phys.,
Pfeilstrasse 26, D-7000 Stuttgart 80 (DE)**

(74) Vertreter: **Teufel, Fritz, Dipl.-Phys., IBM Deutschland
GmbH. Europäische Patentdienste Postfach 265,
D-8000 München 22 (DE)**

## Beschreibung

Die Erfindung betrifft ein Verfahren zur gegenseitigen Ausrichtung von Objekten bei der Röntgenstrahl- und Ionenstrahllithographie und Einrichtungen zur Durchführung des Verfahrens.

Die fortschreitende Verringerung der Abmessungen bei photolithographischen Herstellverfahren, insbesondere für integrierte Halbleiterschaltkreise, stößt an ihre physikalischen Grenzen, wenn die abzubildenden Strukturen in der Größenordnung der verwendeten Lichtwellenlänge liegen und die Auflösung durch Beugungseffekte beschränkt wird.

Als Lithographieverfahren für den Submikronbereich hat man deshalb Korpuskularstrahlen oder Röntgenstrahlen in Betracht gezogen, die sehr viel kürzeren Wellenlängen entsprechen. Von diesen alternativen Verfahren sind bisher Elektronenstrahl-Lithographieverfahren mit gesteuerter Strahlablenkung am weitesten entwickelt, die zum Einschreiben benötigte Zeit wächst dort jedoch mit kleiner werdenden Strukturen stark an. Diesen Nachteil vermeiden Projektionsverfahren, bei denen Masken abgebildet werden, wie es beispielsweise in dem Elektronenstrahl-Schattenwurfverfahren der deutschen Offenlegungsschrift 2 739 502 der Fall ist. Die Auflösung aller Elektronenstrahlverfahren ist jedoch prinzipiell durch den sogenannten Proximity-Effekt beschränkt, der durch Streuung der Elektronen im Photolack und im Substrat die Abbildung sehr feiner Musterelemente verhindert. Es sind zwar Verfahren bekannt, um den Proximity-Effekt bei Elektronenstrahl-Lithographieverfahren zu korrigieren (vgl. europäische Patentanmeldung 80 103 966.0 und den Artikel von M. Parikh in J. Vac. Sci. Techn. Vol. 15, No. 3 [1978], S. 931), doch ist dafür ein relativ hoher Aufwand erforderlich.

Bei Lithographieverfahren, die Ionenstrahlen oder Röntgenstrahlen verwenden, tritt der Proximity-Effekt nicht auf. Die dort sehr geringen Streuprozesse ermöglichen zwar eine hohe Auflösung, erschweren aber andererseits die Ausrichtung von Maske und Substrat vor der Belichtung mit Hilfe der Strahlen, die zum Belichten selbst verwendet werden. Sollen die Ionen selbst zur Ausrichtung (auch Registrieren genannt) verwendet werden, müssen sie durch den Photolack hindurch treten, um an geeignet angeordneten Registriermarken gestreut zu werden. Die gestreuten Ionen müssen nochmals ihrerseits eine ausreichende Energie besitzen, um nochmals durch den Photolack hindurch zu dringen und nach außen auszutreten, um für Registrierzwecke ein nachweisbares Signal zu bilden.

Auswertbare Registriersignale werden unter diesen Umständen nur erhalten, wenn die Energie der auftreffenden Ionen sehr hoch gewählt wird, oder wenn der Photolack über den Registriermarken entfernt wird. Das eine Verfahren führt jedoch zu Gitterschäden im Halbleiter, das andere erfordert einen zusätzlichen Belichtungs- und Entwicklungsschritt.

Ähnliche Probleme aufgrund der geringen Strahlungsdichte und der beschränkten Reichweite verhindern auch bei der Röntgenstrahllithographie, daß in vertretbaren Zeiten ein Registriersignal aufgefangen werden kann.

Für die bisher vorgeschlagenen Ionenstrahl- und Röntgenstrahl-Lithographieeinrichtungen wurde deshalb eine Registrierung mit optischen Methoden vorgeschlagen; Beispiele dafür sind in den Artikeln B. Fay et al., »Optical alignment system for submicron x-ray lithography« in J. Vac. Sci. Techn., 16(6), November/Dezember 1979, S. 1954 und R. L. Seliger et al., »Ion beams promise practical systems for submicrometer wafer lithography« in Electronics, 27. März, 1980, Seite 142 beschrieben. Durch die Verwendung verschiedener Strahlenarten und verschiedener Strahlengänge für die Belichtung einerseits und die Ausrichtung andererseits ergibt sich jedoch das Problem, beide Strahlengänge aufeinander abzustimmen und über größere Zeiträume konstant zu halten. Schwierigkeiten können sich insbesondere bei aufeinanderfolgenden Belichtungen eines Wafers in verschiedenen Geräten des gleichen Typs ergeben.

Die vorliegende Erfindung stellt sich daher die Aufgabe, ein Verfahren und eine Einrichtung anzugeben, mit denen die gegenseitige Ausrichtung zweier Objekte für die Ionenstrahl- oder Röntgenstrahl-Lithographie in einfacher Weise und möglichst fehlerfrei erfolgen kann.

Diese Aufgabe wird durch die in den unabhängigen Ansprüchen 1 und 5 bzw. 6 gekennzeichnete Erfindung gelöst; Ausgestaltungen der Erfindung sind in den Unteransprüchen gekennzeichnet.

Nach der Lehre der Erfindung erfolgt die Ausrichtung (Registrierung) in einem Ionenstrahl- oder Röntgenstrahlbelichtungssystem mit einem zusätzlichen Elektronenstrahl, der nur für Registrierzwecke vorgesehen ist und kollateral zum Beleuchtungsstrahl verläuft. Eine für dieses Registrierverfahren besonders vorteilhafte Belichtungsmaske weist an einer außerhalb des eigentlichen Maskenbereichs liegender Stelle ein spezielles Registriermuster auf, das aus physikalischen Löchern (Durchbrüchen) in einer dünnen, freitragenden Membran besteht.

Ausführungsbeispiele der Erfindung werden nun anhand von Zeichnungen näher erläutert. Es zeigt

Fig. 1 eine Ionenstrahl-Schattenwurf-Belichtungsanlage mit einem in den Belichtungsstrahlengang eingekoppelten Elektronenstrahl zur gegenseitigen Ausrichtung von Maske und Substrat;

Fig. 2A eine schematische Darstellung der Belichtungsmaske während der Ausrichtung;

Fig. 2B eine Aufsicht auf den X-Y-Tisch mit Wafer und Detektoranordnung;

Fig. 3 eine Röntgenstrahl-Schattenwurf-Belichtungsanlage mit eingekoppeltem Elektronenstrahl zur Ausrichtung;

Fig. 4 in den Teilbildern A bis I die Herstellungsschritte für eine Maske zur Röntgenstrahl-Schattenwurfbelichtung.

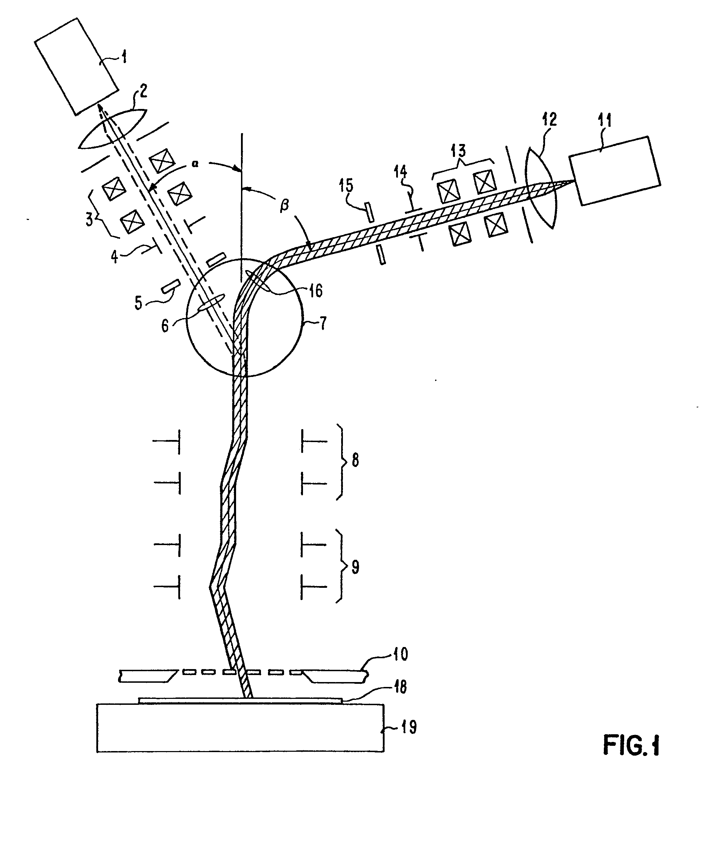

Fig. 1 zeigt den schematischen Aufbau einer Ionenstrahl-Schattenwurf-Belichtungsanlage mit einem separaten Elektronenstrahl zur Ausrichtung (Registrieren) von Maske und Substrat. In Fig. 1 ist der Zustand mit eingeschaltetem Elektronenstrahl dargestellt; der Strahlengang des Ionenstrahls ist punktiert angegeben.

Der zum Belichten eines Substrats 18 durch eine Maske 10 verwendete Ionenstrahl 6 wird in einer Ionenquelle 1 erzeugt, durchläuft eine oder mehrere Linsen 2 (z. B. zur Strahlkollimation), eine Einheit 3 zur Strahlausrichtung (bezüglich Lage und Neigung des Strahls zur optischen Achse), Ausblendelektrodenplatten 4 und eine Stopblende 5, um durch ein senkrecht zur Zeichenebene gerichtetes Magnetfeld 7 so abgelenkt zu werden, daß er mit vertikaler Richtung in die Einheit 8 zur Rasterablenkung (Parallelverschiebung des Ionenstrahls während des Belichtungsvorgangs) eintritt. Der Einheit 8 ist eine weitere Einheit 9 nachgeschaltet, die den Strahl um einen in der Maskenebene liegenden Drehpunkt kippt und so Feinverschiebungen des Schattenwurfbildes auf dem Wafer erzeugt. Einzelheiten dieser Feinverschiebung sind in der europäischen Patentanmeldung 80 103 603.9 beschrieben. Das Substrat (der Wafer) ist auf einem X-Y-Tisch 19 angebracht.

Der zur gegenseitigen Ausrichtung von Maske und Substrat vorgesehene Elektronenstrahl 16 wird in einer Elektronenquelle 11 erzeugt, durchläuft analog zum Ionenstrahl 6 eine Linse 12, eine Einheit 13 zur Strahlausrichtung, Ausblendelektrodenplatten 14 und eine Stopblende 15, bevor er im Magnetfeld 7 so abgelenkt wird, daß er ebenfalls mit vertikaler Orientierung in die Ablenkeinheit 8 eintritt. Die Linsen 2 und 12 sind vorzugsweise vom elektrostatischen Typ, die Einheiten 3 und 13 sind im Beispiel der Fig. 1 als magnetische Einheiten ausgebildet, die Ablenkeinheiten 8 und 9 arbeiten nach dem elektrostatische Ablenkprinzip. Mit den Ausblendelektrodenplatten 4 bzw. 14 können die jeweiligen Korpuskularstrahlen so abgelenkt werden, daß sie nicht mehr durch die Stopblenden 5 bzw. 15 hindurchtreten.

Da die verwendeten, positiv geladenen Ionen und die Elektronen im Magnetfeld 7 in entgegengesetzter Richtung und mit unterschiedlichen Winkelbeträgen abgelenkt werden, müssen Ionenquelle 1 und Elektronenquelle 11 mit den nachgeschalteten strahlformenden Elementen so angeordnet werden, daß die Strahlachsen bezüglich der Vertikalen verschieden Winkel $\alpha$ bzw. $\beta$ ($\alpha < \beta$) einschließen. Nach der Ablenkung verlaufen Ionenstrahl und Elektronenstrahl in gleicher (vertikaler) Richtung, so daß keine Parallaxenfehler zwischen Registrierung und Belichtung auftritt.

Der Ablenkwinkel $\alpha$ eines bewegten geladenen Teilchens in einem senkrecht zur Bewegungsbahn des Teilchens orientierten Magnetfeld beträgt:

$$tg\, \alpha = \frac{l \cdot B}{\sqrt{2\, \frac{m}{q}\, U}},$$

wobei

l = zurückgelegte Strecke im Magnetfeld

B = magnetische Flußdichte

m = Masse des Teilchens

q = Ladung des Teilchens

U = Beschleunigungsspannung, die das Teilchen durchlaufen hat.

Werden im Ionenstrahl einfach geladene Lithiumionen verwendet, so ist der Tangens des Ablenkwinkels $\alpha$ des Ionenstrahls bei gleicher durchlaufener Beschleunigungsspannung um den Faktor

$$\sqrt{m_{Ion}}\,/\,\sqrt{m_{electron}} = 113$$

kleiner als für Elektronen. Der Ablenkwinkel $\alpha$ für den Ionenstrahl beträgt dann beispielsweise 2°, der Ablenkwinkel $\beta$ für den Elektronenstrahl hingegen 76°.

Um die sehr unterschiedliche Beeinflussung von Elektronen und Ionen in magnetischen Feldern zu vermeiden, arbeiten die Ablenkeinrichtungen 8 und 9 mit elektrischen Feldern, die bei gleicher Beschleunigungsspannung U für Ionen und Elektronen denselben Betrag der Ablenkung (aber in verschiedener Richtung) ergeben.

Während des Registriervorgangs wird der Ionenstrahl mit Hilfe der Ausblendelektrodenplatten 4 unterdrückt, während der Belichtung der Elektronenstrahl mit Hilfe der Ausblendelektrodenplatten 14.

Nach dem Einschalten des Elektronenstrahls erfolgt der eigentliche Registriervorgang nach dem Verfahren, das in der Europäischen Patentanmeldung 80 103 603.9 beschrieben ist. Die später anhand von Fig. 4I im einzelnen beschriebene Belichtungsmaske enthält außerhalb des eigentlichen Musterbereichs M einen Registrierbereich R mit einer Vielzahl von Öffnungen, durch die der Elektronenstrahl in eine große Anzahl feiner Strahlen aufgespalten wird. Diese Teilstrahlen werden mit Hilfe der Feinablenkung (Einrichtung 9) gemeinsam über Registriermarken auf der Halbleiterscheibe (Wafer) 18 gelenkt, deren Anordnung der Lochanordnung in dem Maskenteil R entspricht. Das somit erzeugte Registriersignal mit hohem Signal/Rauschverhältnis zeigt Lageabweichungen zwischen Maske und Wafer an, die bei der späteren Belichtung dadurch kompensiert werden, daß der Ionenstrahl um einen entsprechenden Betrag mit Hilfe der Ablenkeinrichtung 9 gekippt wird. Diese Strahlkippung läßt sich schnell durchführen und kann daher für die einzelnen Bereiche mehrfach wiederholt werden (z. B. bei einer schrittweisen Belichtung des Wafers nach dem Step-and-Repeat-Verfahren).

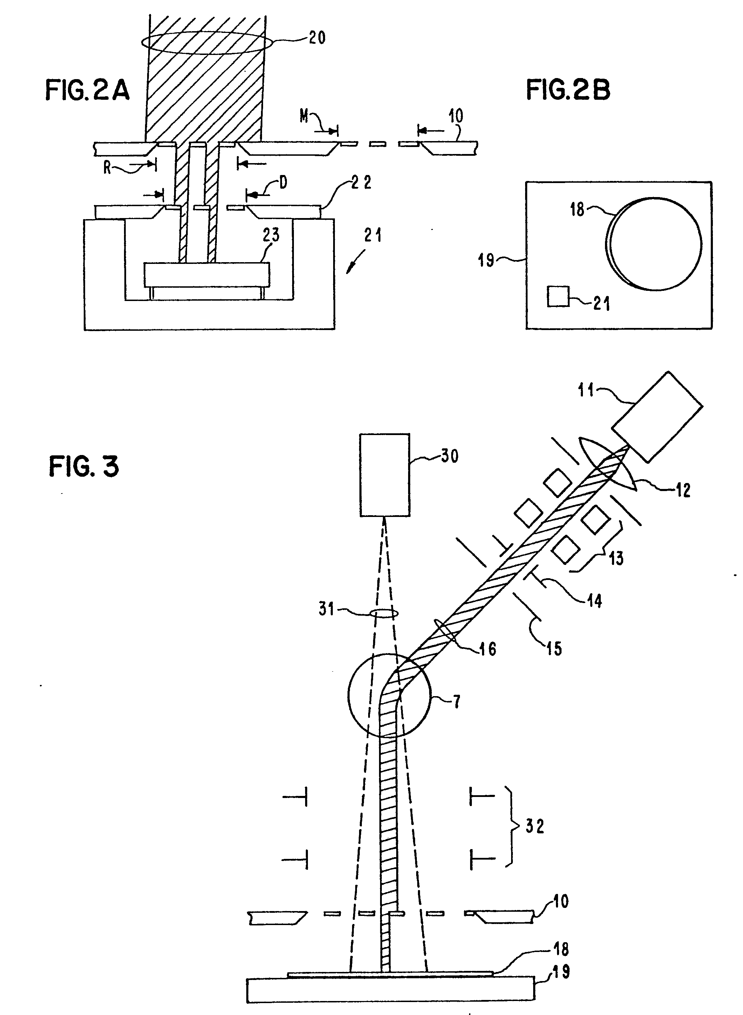

Die Messung des Kippwinkels für den belichtenden Ionenstrahl mit Hilfe eines Elektronenstrahls während des Registriervorgangs setzt voraus, daß Ionenstrahl und Elektronenstrahl den gleichen Strahlengang aufweisen. Zur Eichung dieser beiden Strahlengänge ist eine spezielle Detektoranordnung vorgesehen, die anhand der Fig. 2A und 2B beschrieben wird.

In Fig. 2A besteht eine Eicheinrichtung 21 aus einem Strahlungsdetektor 23, der für beide in den hier betrachteten Lithographiesystemen verwendeten Strahlenarten (Ionen und Elektronen bzw. Röntgenstrahlen und Elektronen) empfindlich ist; derartige Detektoren können beispielsweise mit Halbleiterelementen aufgebaut werden, deren p-n-Grenzschicht direkt an der Oberfläche liegt. Über dem Detektor 23 befindet sich ortsfest eine Detektormaske 22 mit einem Muster D von Löchern, das genau dem Lochmuster R für die Registrierung in der Belichtungsmaske 10 entspricht. Die Eichanordnung 21 ist seitlich versetzt vom Wafer 18 auf dem X-Y-Tisch 19 angeordnet (Fig. 2B).

Zur Eichung von Registrier- und Abbildungsstrahl wird die Eichanordnung 21 mit dem X-Y-Tisch (Kreuzsupport) 19 unter den Registrierbereich R der Mustermaske gefahren. Anschließend wird der Elektronenstrahl 20 auf den Bereich R der Belichtungsmaske 10 gerichtet und die Strahlneigung solange verändert, bis der Detektor 23 ein maximales Ausgangssignal erzeugt. Bei der so bestimmten Strahlneigung wird das Lochmusterbild von R auf das Lochmusterbild D abgebildet.

In einem zweiten Schritt wird anstelle des Elektronenstrahls der Ionenstrahl eingeschaltet und ebenfalls als Bündel 20 auf den Bereich R der Belichtungsmaske gerichtet. Erzeugt der Ionenstrahl das maximale Detektorsignal bei einer anderen Strahlneigung als der Elektronenstrahl (unter Berücksichtigung des verschiedenen Vorzeichens der Strahlablenkung), so sind die beiden Strahlengänge nicht optimal zueinander justiert. Durch Veränderung der Strahlablenkung in den Einrichtungen 3 bzw. 13 zur Strahlausrichtung für Ionen- und Elektronenstrahl können die beiden Strahlengänge auf einfache Weise zueinander ausgerichtet werden.

Fig. 3 zeigt die schematische Darstellung einer Einrichtung zur Röntgenstrahl-Schattenwurfbelichtung, bei der mit einem Belichtungsschritt eine Maske 10 auf einem Wafer 18 projiziert wird. Das divergente Röntgenstrahlbündel 31 wird in einer üblichen Röntgenquelle 30 erzeugt.

Für die Registrierung ist auch hier ein Elektronenstrahlbündel 16 vorgesehen, das mit einem senkrecht zur Papierebene orientierten Magnetfeld 7 in die Achse des Röntgenstrahlbündels 31 gelenkt wird. Die Einrichtungen zur Erzeugung des Elektronenstrahls entsprechen denen von Fig. 1 und tragen dieselben Bezugszeichen. Da Röntgenstrahlen durch magnetische und elektrische Felder nicht abgelenkt werden und keine rasterförmige Belichtung der Maske erfolgt, entfällt beim System nach Fig. 3 die Einheit 8 zur Rasterablenkung; eine elektrostatische Ablenkeinheit 32 zur Kippung des Elektronenstrahls während der Registrierung ist auch hier vorgesehen. Festgestellte Registrierfehler werden hier durch eine Nachjustierung des Wafers (z. B. mit piezoelektrischen Elementen am X-Y-Tisch 19) vor der Röntgenstrahlbelichtung ausgeglichen.

Zur Eichung der beiden Strahlengänge aufeinander wird zuerst ein maximales Detektorsignal mit Röntgenstrahlbeleuchtung erzeugt, indem die Einrichtung 21 mit dem X-Y-Tisch 19 in die entsprechende Position gebracht wird. Anschließend wird der Elektronenstrahl mit Hilfe der Strahlausrichtungs-Einrichtung 13 ausgerichtet. Abgesehen von der fehlenden Ablenkmöglichkeit für Röntgenstrahlen entspricht die in Fig. 3 dargestellte Röntgenstrahl-Lithographieeinrichtung der Ionenstrahl-Lithographieeinrichtung von Fig. 1.

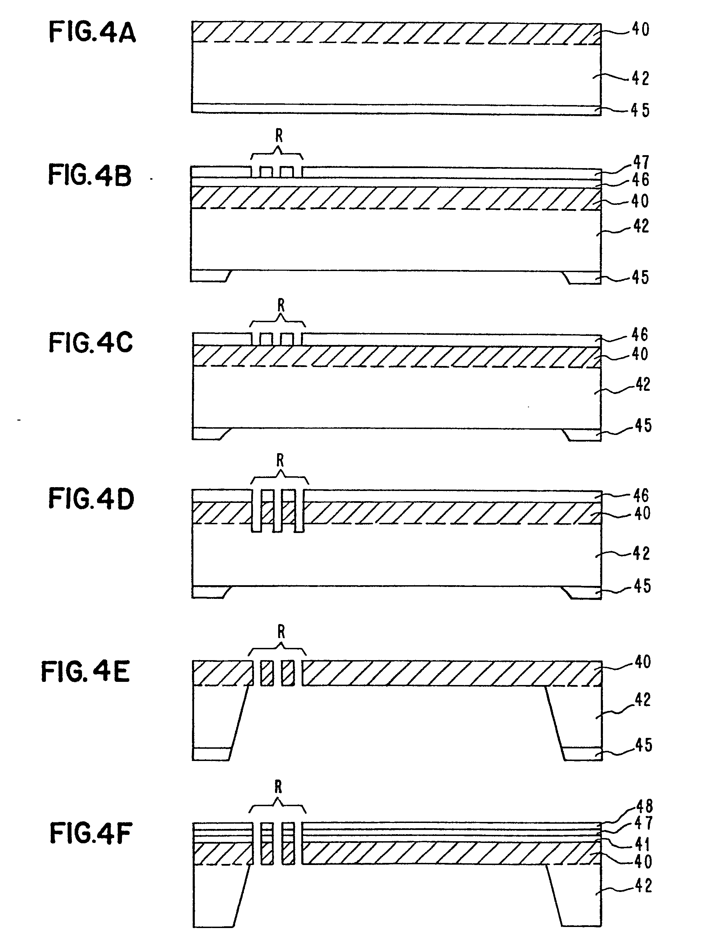

Die für das hier vorgeschlagene Registrierverfahren verwendeten Belichtungsmasken 10 müssen in dem Registrierbereich R ein Muster aus durchgehenden physikalischen Löchern aufweisen, da nur so ein ungehinderter Durchtritt der Elektronen gewährleistet ist. Der eigentliche Musterbereich M der Maske 10 braucht dagegen nicht unbedingt aus einem Lochmuster zu bestehen, da geeignet gewählte Substanzen sowohl wie für Ionenstrahlen als auch für Röntgenstrahlen transparent sind. Eine bevorzugte Struktur der Belichtungsmaske 10 und das dazu erforderliche Herstellungsverfahren werden nun anhand der Fig. 4A bis 4I näher erläutert.

Fig. 4I zeigt die Struktur der fertiggestellten Belichtungsmaske 10, die aus einer dünnen Siliciumschicht 40 mit einer darüberliegenden dünnen Goldschicht 41 besteht. Die Dicke dieser Schicht 40 beträgt einige μm (z. B. 5 μm); diese dünne Schicht wird in ausgewählten Bereichen aus einem Siliciumsubstrat ausgeätzt, dessen verbleibende Teile in Fig. 4I als Stützränder 42a, 42b dargestellt sind. In der dünnen Schicht befindet sich ein Registriermuster R aus durchgehenden Löchern, das während der Registrierung mit einem Elektronenstrahl 43 beaufschlagt wird, und außerdem das eigentliche Maskenmuster M, auf das während der Belichtung der Ionenstrahl bzw. Röntgenstrahl 44 gerichtet wird. Zur Erhöhung des Kontrastes (Verringerung von Streueffekten) besteht der Musterbereich M aus Sacklöchern, so daß an diesen Stellen die Restdicke der Siliciumschicht 40 nur noch rund 25% ihrer sonstigen Dicke beträgt (ungefähr 1 bis 2 μm). Trotz hohem Kontrast für die Ionenstrahl- bzw. Röntgenstrahlbelichtung ergibt sich somit eine ausgezeichnete mechanische Stabilität der Siliciumschicht 40.

Zur weiteren Kontrasterhöhung bei der Ionenstrahllithographie wird die Kristallorientierung der dünnen Schicht 40 entsprechend der kristallographischen Richtung 100 gewählt, so daß die vertikal auftreffenden Ionen in Gitterkanälen ungestört durch die Maske hindurchtreten können (sogenannter Channelling-Effekt).

Das Registriermuster R ist nicht nur für die hier vorgeschlagene Elektronenstrahlregistrierung eine notwendige Voraussetzung, sondern kann auch bei optischen Ausrichtverfahren eingesetzt werden, um besseren Kontrast und Unabhängigkeit vom verwendeten Trägersubstrat zu erzielen.

Die einzelnen Schritte zur Erzeugung der Belichtungsmaske nach Fig. 4I sind in den Fig. 4A bis 4H beschrieben. Entsprechend Fig. 4A wird ein Siliciumwafer 42 mit 100-Kristallorientierung an seiner Vorderseite so mit Bor dotiert, daß in einer Tiefe von ungefähr 5 µm noch eine Borkonzentration von ungefähr $7 \times 10^{19}$ Atomen/cm$^3$ vorhanden ist (Schicht 40). Auf der Waferrückseite wird eine ungefähr 1 µm dicke SiO$_2$-Schicht 45 erzeugt.

In Fig. 4B wird auf der bordotierten Vorderseite eine ungefähr 0,5 µm dicke SiO$_2$-Schicht 46 durch Kathodenzerstäubung aufgebracht und darüber eine ungefähr 0,5 µm dicke elektronenstrahlempfindliche Photolackschicht 47 gelegt. Das im Registrierbereich R gewünschte Lochmuster wird anschließend im Photolack definiert (z. B. mit einem hochauflösenden Elektronenstrahlgriffel) und der Photolack entwickelt. In die rückseitige SiO$_2$-Schicht 45 wird mit konventionellen Naßätztechniken ein Fenster in Chipgröße geätzt.

In Fig. 4C wird mit einem ersten Plasmaätzprozeß (Reactive Ion Etching RIE) das dem Registrierbereich R entsprechende Muster des Photolacks in die SiO$_2$-Schicht 46 geätzt. Dazu kann beispielsweise ein Parallelplattenreaktor mit CHF$_3$ als Reaktionsgas und ungefähr 20 Millitorr Druck verwendet werden.

In Fig. 4D wird die strukturierte SiO$_2$-Schicht 46 von Fig. 4C als Maske für einen zweiten Plamaätzprozeß verwendet, bei dem mit einem Ar/Cl$_2$-Plasma das Lochmuster des Registrierbereichs M in die bordotierte Schicht 40 eingeätzt wird. Die Ätztiefe muß dabei größer sein als die Tiefe der kritischen Ebene (gestrichelt eingezeichnet), in der die Borkonzentration ungefähr $7 \times 10^{19}$ Boratome/cm$^3$ beträgt.

Entsprechend Fig. 4E wird anschließend die Siliciumscheibe 42 durch das Fenster in der SiO$_2$-Schicht 45 anisotrop naßgeätzt, bis bei der Borkonzentration von $7 \times 10^{19}$ Boratomen/cm$^3$ ein Ätzstop eintritt. Die Ätzlösung, die diese Eigenschaften besitzt, besteht aus Äthylendiamin, Brenzkatechin und Wasser. Das Registriermuster M liegt nun als echtes Lochmuster in der dünnen Siliciummembran 40 vor. In den nächsten Prozeßschritten muß nun das eigentliche Belichtungsmuster M in die Siliciummembran 40 definiert werden.

In Fig. 4F wird nach dem Entfernen der noch vorhandenen SiO$_2$-Schichten 45 mit gepufferter Flußsäure auf der Vorderseite der Maske eine ungefähr 0,6 µm dicke Goldschicht 41, eine ungefähr 0,5 µm dicke SiO$_2$-Schicht 48 und eine Photolackschicht 49 (< 0,5 µm) aufgebracht. Die Struktur des Registrierbereichs R ändert sich bei diesen Vorgängen nicht.

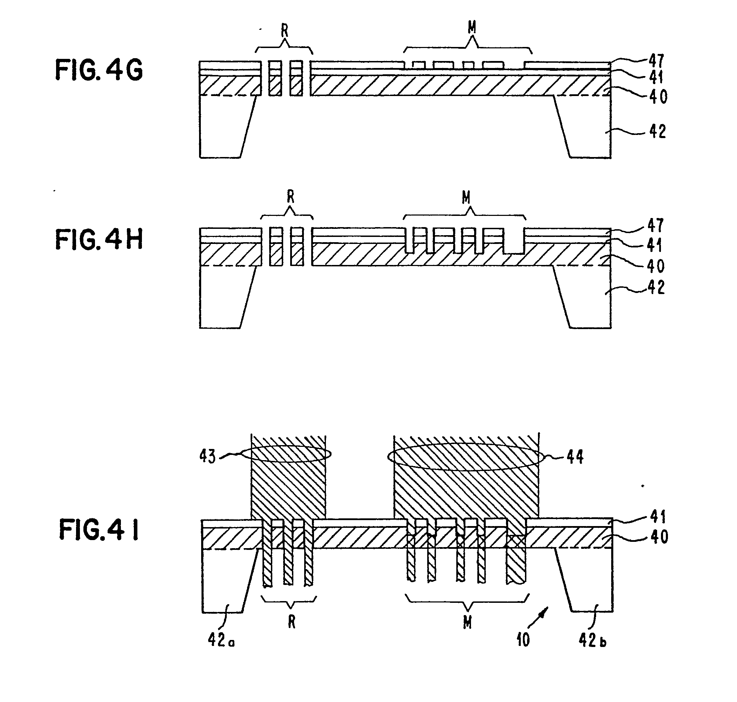

In Fig. 4G wird in der Photolackschicht 49 mit Hilfe eines Elektronenstrahlgriffels (Mustergenerator) das gewünschte Maskenmuster erzeugt, wobei der Elektronenstrahl gleichzeitig zur Ausrichtung dieses Musters auf das bereits vorhandene Lochmuster verwendet werden kann. Nach dem Entwickeln das Photolacks wird wiederum durch Plasmaätzen das Maskenmuster in die SiO$_2$-Schicht 47 geätzt. Diese Schicht dient nun als Maske zum Ätzen der Gold- und Siliciumschichten mit dem obengenannten Ar/Cl$_2$-Plasma. Dieser Ätzprozeß wird dabei so gesteuert, daß im Bereich des Belichtungsmusters M keine durchgehenden Löcher entstehen, sondern rund 25% der dotierten Siliciumschicht 40 übrig bleiben (Fig. 4H). Auf diese Weise können auch Masken mit inselförmigen Strukturen hergestellt werden, die bei durchgehenden Löchern nicht realisierbar sind und in Komplementärmasken aufgespalten werden müssen.

Nach dem Ätzen des Musterbereichs M wird die SiO$_2$-Schicht 47 entfernt, um die gewünschte endgültige Gestalt der Belichtungsmaske nach Fig. 4I zu erhalten. Die Goldschicht 41 dient sowohl für Ionenstrahlen als auch für Röntgenstrahlen als Absorberschicht.

## Patentansprüche

1. Verfahren zur gegenseitigen Ausrichtung (Registrierung) von Objekten bei der Röntgenstrahl- oder Ionenstrahl-Lithographie, dadurch gekennzeichnet, daß die Prüfung der Ausrichtung mit einem Elektronenstrahl (Ausrichtstrahl 16) erfolgt, der teilweise kollateral zum Belichtungsstrahlengang (6, 31) verläuft und während des eigentlichen Belichtungsvorgangs ausgeblendet wird.

2. Verfahren nach Anspruch 1, wobei ein Substrat (Wafer 18) mit einem Ionenstrahl (6) durch eine Maske (10) hindurch belichtet wird und der Ionenstrahl (6) um einen in der Maskenebene liegenden Punkt gekippt werden kann, dadurch gekennzeichnet, daß nach einer Grobausrichtung von Maske und Substrat der erforderliche Kippwinkel für die exakte Belichtung mit dem Elektronenstrahl ermittelt wird, indem dieser durch einen Registrierbereich (R) der Maske auf einen Detektorbereich des Substrats projiziert wird und daß bei der nachfolgenden Belichtung der Ionenstrahl um den gleichen Winkel gekippt wird.

3. Verfahren nach Anspruch 1, wobei ein Substrat (Wafer 18) mit Röntgenstrahlen durch eine Maske (10) hindurch belichtet wird, dadurch gekennzeichnet, daß der Elektronenstrahl durch einen Registrierbereich (R) der Maske (10) auf einen Detektorbereich des Substrats projiziert wird und Registrierfehler zwischen Maske und Substrat durch eine Verschiebung des zu belichtenden Substrats relativ zur Maske ausgeglichen werden.

4. Einrichtung zur Durchführung des Verfahrens nach Anspruch 1 oder 2, dadurch gekennzeichnet, daß in einem Ionenstrahl-Belichtungssystem (Fig. 1) der Ionenstrahl (6) und der Elektronenstrahl (16) ein senkrecht zu den Strahlrichtungen verlaufendes Magnetfeld (7) durchsetzen und durch dieses kollateral gemacht werden.

5. Einrichtung zur Durchführung des Verfahrens nach Anspruch 1 oder 3, dadurch gekennzeichnet, daß in einem Röntgenstrahl-Belichtungssystem (Fig. 3) der Elektronenstrahl durch ein senkrecht zur Strahlrichtung verlaufendes Magnetfeld (7) kollateral zur Achse des Röntgenstrahlbündels (31) gemacht wird.

6. Einrichtung nach einem der Ansprüche 4 oder 5, dadurch gekennzeichnet, daß zur Prüfung der Kollinearität von Belichtungs- und Elektronenstrahl eine Detektoreinrichtung (23) mit darüber angeordneter Detektormaske (22) vorgesehen ist, die durch den Registrierbereich (R) der auszurichtenden Maske (10) hindurch nacheinander vom Belichtungsstrahl (6; 31) und vom Elektronenstrahl (16) beaufschlagt wird, wobei wenigstens ein Strahlengang so verändert wird, daß die Optima der Detektorsignale bei gleicher Strahlneigung von Belichtungs- und Elektronenstrahl auftreten.

7. Einrichtung nach einem der Ansprüche 4 bis 6, dadurch gekennzeichnet, daß die Belichtungsmaske (10) eine dünne Siliciumschicht (40) umfaßt und der vom eigentlichen Musterbereich (M) getrennt angeordnete Registrierbereich (R) durchgehende Löcher aufweist.

8. Einrichtung nach Anspruch 7, dadurch gekennzeichnet, daß der Musterbereich (M) der Belichtungsmaske (10) Sacklöcher aufweist.

9. Einrichtung nach Anspruch 6, dadurch gekennzeichnet, daß die Detektormaske (22) und der Registrierbereich (R) der auszurichtenden Maske (10) gleiche Lochmuster aufweisen.

## Claims

1. Method for mutually aligning (registering) objects in X-ray or ion beam lithography, characterized in that the alignment is checked by means of an electron beam (alignment beam 16) extending partly collaterally to the exposure beam path (6, 31) and which is blanked during the actual exposure process.

2. Method according to claim 1, wherein a substrate (wafer 18) is exposed by means of an ion beam (6) through a mask (10), and the ion beam (6) can be tilted about a point lying in the mask plane, characterized in that after coarse alignment of mask and substrate, the tilting angle necessary for accurate alignment is determined by means of the electron beam by projecting said beam through a registration area (R) of the mask on to a detector region of the substrate, and that during the subsequent exposure, the ion beam is tilted through the same angle.

3. Method according to claim 1, wherein a substrate (wafer 18) is exposed by means of X-rays through a mask (10), characterized in that the electron beam is projected through a registration area (R) of the mask (10) on to a detector region of the substrate, and registration errors between mask and substrate are compensated for by displacing the substrate to be exposed relative to the mask.

4. Apparatus for implementing the method according to claim 1 or 2, characterized in that in an ion beam exposure system (Fig. 1), the ion beam (6) and the electron beam (16) permate a magnetic field (7), extending perpendicularly to the beam directions, thus being made collateral by said field.

5. Apparatus for implementing the method according to claim 1 or 3, characterized in that in an X-ray exposure system (Fig. 3), the electron beam is made collateral to the axis of the X-ray beam (31) by a magnetic field (7) extending perpendicularly to the direction of said beam.

6. Apparatus according to any one of the claims 4 or 5, characterized in that for checking the collinearity of the exposure and the electron beam, a detector means (23) is provided on top of which a detector mask (22) is arranged which through the registration area (R) of the mask (10) to be aligned is successively subjected to the exposure beam (6; 31) and the electron beam (16), changing at least one beam path such that the optima of the detector signals occur when the exposure and the electron beam have the same inclination.

7. Apparatus according to any one of the claims 4 to 6, characterized in that the exposure mask (10) consists of a thin silicon layer (40), and the registration area (R), separated from the actual pattern area (M), has through-holes.

8. Apparatus according to claim 7, characterized in that the pattern area (M) of the exposure mask (10) has blind holes.

9. Apparatus according to claim 6, characterized in that the detector mask (22) and the registration area (R) of the mask (10) to be aligned have the same hole pattern.

## Revendications

1. Procédé pour aligner de façon réciproque des objects selon une méthode de lithographie à rayon X ou à faisceau d'ions, caractérisé en ce que l'alignement est vérifié au moyen d'un faisceau d'électrons (faisceau d'alignement 16), en partie collatéral au trajet du faisceau irradiant (6, 31), qui est réduit par un diaphragme pendant l'operation d'exposition proprement dit.

2. Procédé selon la revendication 1, où on irradie à l'aide d'un faisceau d'ions (6) un substrat (tranche 18) à travers un masque (10), où ledit faisceau d'ions (6) est dévié par rapport à un point situé dans le plan du masque, caractérisé en ce que l'angle d'inclinaison nécessaire pour irradier de façon précise à l'aide du faisceau d'électrons est déterminé selon un alignement grossier du masque par rapport au substrat, ledit faisceau d'électrons étant projeté sur une zone de détection du substrat à travers une zone d'alignement R dudit masque et, en ce que le faisceau d'ions est dévié selon le meme angle lors de la prochaine exposition.

3. Procédé selon la revendication 1, caractérisé en ce qu'un substrat (tranche 18) est irradié par des rayons X à travers un masque (10), caractérisé en ce que ledit faisceau d'électrons est projeté sur une zone de détection dudit substrat à travers une zone d'alignement R dudit masque (10) et, en ce que des erreurs d'alignement entre ledit masque et ledit substrat sont redressées en décalant ledit substrat à irradier par rapport audit masque.

4. Dispositif pour réaliser le procédé selon la revendication 1 ou 2, caractérisé en ce que le faisceau d'ions (6) et le faisceau d'électrons (16) établissent dans un système d'exposition à faisceau d'ions (figure 1) un champ magnétique (7) perpendiculaire aux directions respectives desdits faisceau et, en ce que ces faisceau sont disposés collatéraux par ce camp magnétique.

5. Dispositif pour réaliser le procédé selon la revendication 1 ou 3, caractérisé en ce que, dans un système d'exposition à rayon X (figure 3), ledit faisceau d'électrons est placé collatéral à l'axe du pinceau de rayons X (31) au moyen d'un champ magnétique perpendiculaire à la direction du rayon X.

6. Dispositif selon une des revendications 4 ou 5, caractérisé en ce que, afin de vérifier la collinéarité du faisceau d'électrons et du faisceau d'exposition, il est prévu un détecteur (23) sur lequel est disposé un masque détecteur (22), qui est exposé à travers la zone d'alignement R dudit masque à aligner (10) successivement par le faisceau d'expostion et le faisceau d'électrons (16), où au moins un traject de faisceau est modifié de telle sorte que les niveaux optimum des signaux de détection sont générés pour une meme déviation du faisceau d'exposition et du faisceau d'électrons.

7. Dispositif selon une des revendications 4 et 6, caractérisé en ce que ledit masque d'exposition (10) comprend une couche de silicium mince (40) et, en ce que la zone d'alignement (R) à distance de la zone de motif proprement dit (M) comporte des trous physiques.

8. Dispositif selon la revendication 7, caractérisé en ce que la zone de motif (M) dudit masque d'exposition (10) comporte des trous pleins.

9. Dispositif selon la revendication 6, caractérisé en ce que ledit masque détecteur (22) et ladite zone d'alignement (R) dudit masque d'alignement (10) comportent des motifs de trous similaires.

FIG.1

FIG.2A

FIG.2B

FIG. 3

**FIG.4A**

40
42
45

**FIG.4B**

R

47
46
40
42
45

**FIG.4C**

R

46
40
42
45

**FIG.4D**

R

46
40
42
45

**FIG. 4E**

R

40
42
45

**FIG.4F**

R

48
47
41
40
42

FIG. 4G

FIG. 4H

FIG. 4 I